# EUROPÄISCHE PATENTSCHRIFT

(11) **EP 0 698 584 B1**
(45) Veröffentlichungstag und Bekanntmachung des Hinweises auf die Patenterteilung: **07.07.1999**
(21) Anmeldenummer: 95107832.8
(22) Anmeldetag: 23.05.1995
(51) Int. Cl.: C03C 17/22, C23C 16/02, C23C 16/32, C23C 16/44, H01L 21/00

(54) **Beschichtetes Bauteil aus Quarzglas**
Coated quartz glass component
Element en verre de quartz revêtu

(30) Priorität: 23.08.1994 DE 4429825
(43) Veröffentlichungstag der Anmeldung: 28.02.1996
(73) Patentinhaber: Heraeus Quarzglas GmbH, 63450 Hanau (DE)
(72) Erfinder: Breidenbach, Poul E., D-63486 Bruchköbel (DE); Hellmann, Dietmar, D-63589 Linsengericht (DE); Leber, Helmut, Dr., D-63454 Hanau (DE)
(74) Vertreter: Staudt, Armin Walter

(56) Entgegenhaltungen:
- DE-A- 3 441 056

## Beschreibung

Die Erfindung betrifft ein Bauteil für die Durchführung halbleitertechnologischer Prozesse aus Quarzglas, mit einer Beschichtung, deren Oberfläche aus Siliziumkarbid besteht.

Bei der Herstellung von Halbleiter-Bauelementen werden Substratoberflächen häufig mit Siliziumoxid, Siliziumnitrid oder Silizium beschichtet. Hierfür werden die bekannten CVD-Verfahren angewandt. Die Beschichtungsmaterialien schlagen sich dabei auf allen Wandungen im Reaktionsraum, also auch auf denjenigen des Ofens, der Haltemittel für die Substrate oder den Oberflächen anderer Bauteile nieder. Von Quarzglasoberflächen platzen diese Schichten ab einer gewissen Schichtdicke ab und können dadurch zu Partikelproblemen führen. Um dies zu verhindern, müssen die entsprechenden Bauteile immer wieder gereinigt werden. Üblicherweise wird für die Entfernung von Silizium-Schichten eine aus einem Gemisch von HF und HNO₃ bestehende Ätzlösung eingesetzt. Diese Ätzlösung greift jedoch auch das Quarzglas selbst an. Zur Schaffung eines Ätzstops für diese Ätzlösung ist es bekannt, die Oberfläche des Bauteils mit SiC zu versehen.

Aus der japanischen Patentanmeldung JP 62-116728 ist eine Ausström-Düse aus Quarzglas bekannt, die bei einem Epitaxie-Verfahren als Gaseinlaßöffnung in einem Reaktionsofen dient. Die bekannte Düse weist eine Oberflächenschicht aus Siliziumkarbid auf. Zwischen der Oberfläche des Quarzglases und der Siliziumkarbidschicht ist eine Zwischenschicht vorgesehen, die aus Silizium oder aus Siliziumnitrid besteht.

Aufgrund der großen Unterschiede in den Ausdehnungskoeffizienten von Quarzglas und Siliziumkarbid, bzw. Silizium, weisen die bekannten Schichten eine geringe Temperaturwechselbeständigkeit auf. Dies beruht einerseits auf der relativ festen Haftung derartiger Schichten auf Quarzglas, zum anderen auf den Unterschieden der Ausdehnungskoeffizienten der Schichtmaterialien und des Quarzglases, und den dadurch bei Temperaturwechseln in der Beschichtung induzierten Spannungen. Dies führt zu Abplatzungen oder zu Mikrorissen in den Schichten, wodurch sowohl die Beständigkeit der bekannten Bauteile gegen die oben genannte Ätzlösungen, insbesondere gegenüber dem Gemisch von HF und HNO_{3,} als auch der Schutz vor Ausdiffusion von Halbleitergiften aus dem Bauteil vermindert ist.

Der Erfindung liegt daher die Aufgabe zu Grunde, ausgehend von den bekannten Bauteilen, ein beschichtetes Bauteil anzugeben, das eine gute Temperaturwechselbeständigkeit und eine Langzeitstabilität hinsichtlich seiner chemischen Beständigkeit gegen Flußsäure und Salpetersäure sowie eine Mischung der beiden Säuren und der Ausdiffusion von Halbleitergiften aufweist.

Diese Aufgabe wird ausgehend von dem bekannten Bauteil dadurch gelöst, daß die Beschichtung eine Gradientenschicht aus Siliziumkarbid und mindestens einer weiteren, eine geringere Härte und einen kleineren Elastizitätsmodul als Siliziumkarbid aufweisenden Komponente, deren Konzentration über die Schichtdicke von innen nach außen abnimmt, umfaßt. Durch die erfindungsgemäße Gradientenschicht wird die Temperaturwechselbeständigkeit der Beschichtung wesentlich verbessert. Als Gradientenschicht wird eine Schicht bezeichnet, die mindestens zwei Komponenten, darunter Siliziumkarbid enthält, wobei die Konzentrationen der Komponenten über die Dicke der Gradientenschicht einen Gradienten aufweisen. Der Konzentrationsgradient kann stetig oder auch stufenförmig sein. Die Verbesserung der Temperaturwechselbeständigkeit der Beschichtung kann zum einen auf einem geeigneten thermischen Ausdehnugskoeffizienten der weiteren Komponente beruhen, der vorteilhafterweise zwischen demjenigen des Quarzglases und demjenigen von Siliziumkarbid liegt. Die wesentliche Funktion der Komponente besteht aber in ihrem Beitrag zum Abbau der Spannungen zwischen dem Bauteil und der Beschichtung. Dies wird dadurch erreicht, daß die weitere Komponente eine geringere Härte und einen kleineren Elastizitätsmodul (E-Modul) aufweist als Siliziumkarbid. Der dadurch erreichte Spannungsabbau könnte darauf beruhen, daß die weitere Komponente aufgrund ihrer geringen Härte und des kleineren Elastizitätsmoduls mechanischen Spannungen leicht nachgibt und daher als mechanischer Puffer zwischen dem Quarzglas und der siliziumkarbidhaltigen Oberfläche wirkt. In der Literatur werden für die Härte von Quarzglas Werte von 7 (gemessen nach Mohs) und von 820 (gemessen nach Knoop) und von Siliziumkarbid Härten von mindestens 9,2 (Mohs) und um 2480 (Knoop) angegeben. Der E-Modul von Quarzglas liegt bei etwa 75 GN/m², derjenige von Siliziumkarbid im Bereich von 240 GN/m² bis 400 GN/m². Der Konzentrationsgradient innerhalb der Gradientenschicht trägt zusätzlich zum Spannungsabbau bei.

Es wird angenommen, daß der Konzentrationsgradient von außen nach innen eine Verlagerung der Maximalspannung von der spannungsempfindlichen Grenzfläche zwischen Quarzglas und Beschichtung weg in die Beschichtung selbst bewirkt. Aufgrund der verbessertren Temperaturwechselbeständigkeit der erfindungsgemäßen Beschichtung ist die Gefahr der Bildung von Rissen in der Beschichtung verringert und daher die Langzeitstabilität der erfindungsgemäßen Bauteile hinsichtlich ihrer chemischen Beständigkeit und ihrer Dichtigkeit gegen die Ausdiffusion von Halbleitergiften verbessert.

Besonders bewährt haben sich Bauteile, bei denen die weitere Komponente siliziumhaltig ist, insbesondere Silizium, Siliziumnitrid und/oder Siliziumoxid enthält. Der Siliziumanteil erleichtert eine chemische Löslichkeit des Siliziumkarbids in der weiteren Komponente. Dies bewirkt einer im Verglich zu einer Dispersion von SiC-Partikeln in der Komponente homogeneren Spannungsverlauf über die Dicke der Gradientenschicht und damit eine verbesserte Temperaturwechselbeständigkeit des beschichteten Bauteils. Insbesondere zeichnet sich metallisches Silizium durch eine im Vergleich zu Siliziumkarbid sehr geringe Härte aus. Die Härte von Silizium liegt noch unterhalb der für Quarzglas angegebenen Werte. In der Literatur werden Werte für den E-Modul von einkristallinem Silizium um 100 GN/m² und für Siliziumnitrid im Bereich zwischen 140 GN/m² und 210 GN/m² angegeben. Der durch die siliziumhaltige Komponente bewirkte Spannungsabbau wird noch dadurch unterstützt, daß der thermische Ausdehnungskoeffizient der weiteren Komponente im Bereich um Raumtemperatur zwischen demjenigen von Quarzglas (α = 0,5 x 10 ⁻⁶ pro Grad) und demjenigen von Siliziumkarbid (α = 4,3 x 10 ⁻⁶ pro Grad - 5,8 x 10 ⁻⁶ pro Grad) ) liegt. So weist Silizium einen entsprechenden thermischen Ausdehungskoeffizienten α um 3 x 10 ⁻⁶ pro Grad und Siliziumnitrid einen Ausdehungskoeffizienten α_{20/1000} im Bereich von 2,9 x 10 ⁻⁶ pro Grad bis 3,5 x 10 ⁻⁶ pro Grad auf.

Bevorzugt wird eine Ausführungsform des beschichteten Bauteils, bei dem die Oberfläche der Beschichtung von der Gradientenschicht gebildet wird. Diese Ausführungsform des Bauteils ist besonders einfach herstellbar und gewährleistet eine gute chemische Beständigkeit gegen den Angriff von Säuren. Ein günstiger Verlauf der mechanischen Spannungen über die Dicke der Gradientenschicht wird mit einer Beschichtung erreicht, bei der der Anteil von Siliziumkarbid in der Gradientenschicht über die Schichdicke von innen nach außen kontinuierlich zunimmt. Eine kontinuierliche Zunahme der SiC-Konzentartion verbessert die Temperaturwechselbeständigkeit.

Besonders bewährt hat sich ein Bauteil mit einer Gradientenschicht, die Silizium und Siliziumkarbid enthält, wobei der Anteil an metallischemSilizium im Bereich der Oberfläche der Beschichtung in der Gradientenschicht gleich Null ist. Die Oberfläche wird ausschließlich durch Siliziumkarbid gebildet. Ein derartiges Baute zeichnet sich durch eine gute chemische Beständigkeit gegen Säureangriff, insbesondere auch gegen ein Säuregemisch aus Flußsäure und Salpersäure aus, wie es üblicherweise zum Abätzen von Silizium verwendet wird. Diese Säurebeständigkeit wird durch eine dichte Siliziumcarbid-Oberfläche des Bauteils erreicht. Metallisches Silizium weist eine gegenüber SiC sehr geringe Härte auf. Sein Anteil in der Gradientenschicht nimmt von innen, wo er beispielsweise 100 % betragen kann, nach außen ab. Der hohe Siliziumanteil in der Gradientenschicht in dem dem Quarzglas des Bauteils zugeordneten Bereich der Gradientenschicht bewirkt einen Abbau mechanischer Spannungen, die ansonsten zwischen der SiC-haltigen Oberfläche und dem Qurazglas entstehen würden. Dadurch wird eine sehr gute Temperaturwechselbeständigkeit der Beschichtung erreicht. Der Anteil an metallischem Silizium im Bereich der Oberfläche von Null gewährleistet wiederum die erforderliche chemische Beständigkeit.

Als vorteilhaft hat sich ein Bauteil mit einer Gradientenschicht erwiesen, deren Schichtdicke im Bereich zwischen 5 µm und 100 µm liegt. Bei dünneren Schichten ist der durch die Gradientenschicht bewirkte Spannungsabbau nicht ausreichend, dickere Schichten neigen zum Abplatzen.

Dabei hat es sich als günstig erwiesen, die Gradientenschicht mit einer Zwischenschicht aus Silizium zu unterlegen. Dadurch, daß die Gradientenschicht in ihrem dem Quarzglas des Bauteils zugewandten Bereich in eine Schicht aus Silizium übergeht, werden die durch die unterschiedlichen thermischen Ausdehnungskoeffizeinten von Quarzglas und Siliziumkarbid hervorgerufenen Spannungen besonders wirkungsvoll vermindert oder in einen von der empfindlichen Quarzglasoberfläche entfernten Bereich innerhalb der Beschichtung verlagert. Dabei hat sich eine Dicke der Siliziumschicht im Bereich von 5 µm und 100 µm als günstig erwiesen.

Es wird eine Ausführungsform des beschichteten Bauteils bevorzugt, bei der die Oberfläche des Bauteils chemisch aufgerauht ist. Die Aufrauhung bewirkt eine bessere Haftung der Beschichtung auf dem Quarzglas. Die chemische Aufrauhung erzeugt dabei gegenüber einer mechanischen Aufrauhung, beispielsweise durch Sandstrahlen, keine Vorschädigung der Quarzglasoberfläche. Ihre wesentliche Funktion kommt der Aufrauhung aber in Verbindung mit der Gradientenschicht zu. Es hat sich nämlich gezeigt, daß die aufgerauhte Oberfläche wesentlich zum Spannungsabbau in der Gradientenschicht beiträgt. Möglicherweise beruht dieser Effekt darauf, daß die Aufrauhung die Ausbildung einer gleichmäßigen, ebenen Spannungsfront im Bereich der Grenzfläche zwischen dem Bauteil und seiner Beschichtung verhindert. Als besonders wirkungsvoll hat sich eine Aufrauhung des Quarzglases mit einer mittleren Rauhtiefe im Bereich 0,5 µm bis 10 µm erwiesen.

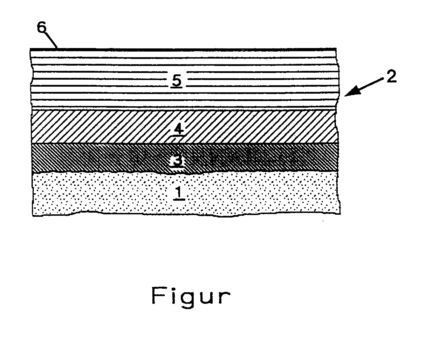

Ein Ausführungsbeispiel der Erfindung ist in der Zeichnung dargestellt und wird nachfolgend näher erläutert. In der einzigen Figur ist ein Schnitt durch ein erfindungsgemäßes Bauteil mit einer darauf aufgebrachten Beschichtung dargestellt.

Die Bezugsziffer 1 ist dem Bauteil aus Quarzglas zugeordnet. Dabei kann es sich beispielsweise um ein Quarzglasboot zur Aufnahme von Silizium-Wafern handeln. Die Oberfläche des Bauteils 1 ist mit einer mittleren Rauhtiefe von ca. 1 µm chemisch aufgerauht. Mit der Bezugsziffer 2 ist die auf dem Bauteil 1 aufgebrachte Beschichtung insgesamt bezeichnet. Die Beschichtung 2 besteht aus drei Schichten 3, 4, 5. Bei der an das Bauteil 1 unmittelbar angrenzenden Schicht handelt es sich um eine ca. 10 µm dicke Zwischenschicht 3 aus polykristallinem Silizium. Auf die Zwischenschicht 3 folgt eine Gradientenschicht 4. Die Gradientenschicht 4, die aus Silizium und Siliziumkarbid besteht, hat eine Dicke von etwa 15 µm. In der Gradientenschicht 4 nimmt der Anteil an Siliziumkarbid von ihrem an die Zwischenschicht 3 angrenzenden Bereich an kontinuierlich zu. Der Anteil an metallischem Silizium nimmt über die Dicke der Gradientenschicht 4 dementsprechend ab. Auf die Gradientenschicht 4 ist eine Oberflächenschicht 5 aus Siliziumkarbid aufgebracht. Die Oberflächenschicht 5 weist eine Dicke von ca. 35 µm auf. Die Oberfläche der Oberflächenschicht 5, die gleichzeitig die Oberfläche 6 der Beschichtung 2 bildet, besteht aus reinem Siliziumkarbid. Die Schichtdicke der Beschichtung 2 beträgt insgesamt etwa 60 µm.

Die Beschichtung 2 wird in einem Standard-CVD-Ofen in einem einzigen Arbeitsgang aufgebracht. Zum Beschichten mit amorphem Silizium wird bei einer Temperatur von etwa 600 °C SiH₄ in den Ofen eingeleitet und auf der Oberfläche des Bauteils abgeschieden. Zur Herstellung der Gradientenschicht 4 wird dem Prozeßgas zunehmend ein kohlenstoffhaltiges Gas, beispielsweise CH₄, sowie Wasserstoff beigemischt. Dabei wird auch die Temperatur innerhalb des Ofens erhöht. Zur Herstellung der Oberflächenschicht 5 beträgt die Ofentemperatur etwa 850 °C. Das Verhältnis von Silizium aus SiH₄ und von Kohlenstoff aus CH₄ entspricht dabei dem stöchiometrischen Verhältnis von 1:1.

Aufgrund der Unterschiede zwischen den thermischen Ausdehungskoeffizienten von reinem Quarzglas und Silizium und insbesondere von Siliziumkarbid entstehen beim Abkühlen von den Prozeßtemperaturen Spannungen in der Beschichtung 2. Diese können zum Abplatzen der Schichten 3,4,5 führen. Das Aufrauhen der Oberfläche des Bauteils 1 verbessert nicht nur die Haftung der Zwischenschicht 3, sondern sie trägt auch zum Abbau der Spannungen in der Beschichtung 2 bei. Dies kann darauf zurückgeführt werden, daß das Aufrauhen das Entstehen einer ebenen Spannungsfront verhindert. Die Zwischenschicht 3 haftet auf der Quarzglasoberfläche des Bauteils 1 sehr gut. Wesentlich für den Abbau der Spannungen in der Beschichtung 2 ist der Konzentrationsgradient in der Gradientenschicht 4. Der Spannungsabbau beruht darauf, daß die weitere Komponente in der Gradientenschicht 4 neben Siliziumkarbid, in diesem Fall Silizium, eine wesentlich geringere Härte und einen wesentlich kleineren E-Modul aufweist als das Siliziumkarbid selbst. Aufgrund seines thermischen Ausdehnugskoeffizienten von ca. 3x10⁻⁶ je Grad, der zwischen demjenigen von Quarzglas und von Siliziumkarbid liegt, trägt das Silizium der Gradientenschciht 4 weiter zum Abbau der Spannungen zwischen der Oberfläche des Bauteils 1 un der Oberflächenschicht 5 bei. Die Oberflächenschicht 5 aus reinem Siliziumkarbid gewährleistet sowohl eine hohe Dichtigkeit der Beschichtung gegenüber Ausdiffusion von Verunreinigungen aus dem Bauteil 1 als auch eine hohe chemische Beständigkeit gegenüber Säureangriff, insbesondere gegen Flußsäure und Salpetersäure sowie eine Mischung der beiden Säuren.
Insgesamt zeichnet sich die Beschichtung 2 somit durch eine gute Temperaturwechselbeständigkeit und eine hohe Langzeitstabilität hinsichtlich seiner chemischen Beständigkeit und der Ausdiffusion von Halbleitergiften aus.

## Patentansprüche

1. Bauteil für die Durchführung halbleitertechnologischer Prozesse aus Quarzglas, mit einer Beschichtung, deren Oberfläche aus Siliziumkarbid besteht, dadurch gekennzeichnet, daß die Beschichtung (2) eine Gradientenschicht (4) aus Siliziumkarbid und mindestens einer weiteren, eine geringere Härte und einen kleineren Elastizitätsmodul als Siliziumkarbid aufweisenden Komponente, deren Konzentration über die Schichtdicke von innen nach außen abnimmt, umfaßt.

2. Bauteil nach Anspruch 1, dadurch gekennzeichnet, daß die weitere Komponente siliziumhaltig ist.

3. Bauteil nach Anspruch 2, dadurch gekennzeichnet, daß die weitere Komponente Silizium, Siliziumnitrid und/oder Siliziumoxid enthält.

4. Bauteil nach einem der vorhergehenden Ansprüche, dadurch gekennzeichnet, daß die Oberfläche (6) der Beschichtung (2) von der Gradientenschicht (4) gebildet wird.

5. Bauteil nach einem der vorhergehenden Ansprüche, dadurch gekennzeichnet, daß der Anteil von Siliziumkarbid in der Gradientenschicht (4) über die Schichtdicke von innen nach außen kontinuierlich zunimmt.

6. Bauteil nach einem oder mehreren der Ansprüche 1 bis 5, dadurch gekennzeichnet, daß die Gradientenschicht (4) Silizium und Siliziumkarbid enthält und daß im Bereich der Oberfläche (6) der Beschichtung (2) der Anteil an metallischem Silizium in der Gradientenschicht (4) gleich Null ist.

7. Bauteil nach einem oder mehreren der Ansprüche 1 bis 6, dadurch gekennzeichnet, daß die Schichtdicke der Gradientenschicht (4) im Bereich zwischen 5 µm und 100 µm liegt.

8. Bauteil nach einem oder mehreren der vorhergehenden Ansprüche, dadurch gekennzeichnet, daß die Gradientenshicht (4) mit einer Zwischenschicht (3) aus Silizium unterlegt ist.

9. Bauteil nach einem oder mehreren der vorhergehenden Ansprüche, dadurch gekennzeichnet, daß die Oberfläche des Bauteils (1) chemisch aufgerauht ist.

10. Bauteil nach Anspruch 9, dadurch gekennzeichnet, daß die Oberfläche des Bauteils (1) mit einer mittleren Rauhtiefe um 1 µm aufgerauht ist.

## Claims

1. Quartz glass component for carrying out processes in semiconductor technology, having a coating whose surface consists of silicon carbide, characterized in that the coating (2) comprises a gradient layer (4) of silicon carbide and at least one further component which has a lower hardness and a lower modulus of elasticity than silicon carbide and whose concentration decreases over the layer thickness from the inside to the outside.

2. Component according to Claim 1, characterized in that the further component is silicon-containing.

3. Component according to Claim 2, characterized in that the further component contains silicon, silicon nitride and/or silicon oxide.

4. Component according to any of the preceding Claims, characterized in that the surface (6) of the coating (2) is formed by the gradient layer (4).

5. Component according to any of the preceding Claims, characterized in that the proportion of silicon carbide in the gradient layer (4) increases continuously over the layer thickness from the inside to the outside.

6. Component according to one or more of Claims 1 to 5, characterized in that the gradient layer (4) contains silicon and silicon carbide and that the proportion of metallic silicon in the gradient layer (4) is equal to zero in the region of the surface (6) of the coating (2).

7. Component according to one or more of Claims 1 to 6, characterized in that the layer thickness of the gradient layer (4) is in the range from 5 µm to 100 µm.

8. Component according to one or more of the preceding Claims, characterized in that the gradient layer (4) is underlaid with an intermediate layer (3) of silicon.

9. Component according to one or more of the preceding Claims, characterized in that the surface of the component (1) is chemically roughened.

10. Component according to Claim 9, characterized in that the surface of the component (1) is roughened with an average peak-to-valley height of about 1 µm.

## Revendications

1. Elément en verre de quartz pour la mise en oeuvre de processus appliqués dans la technologie des semi-conducteurs, doté d'un revêtement dont la surface se compose d'un carbure de silicium, caractérisé en ce que le revêtement (2) comprend une couche (4) à gradient d'indice composée de carbure de silicium et d'un autre composant présentant une dureté moindre et un module d'élasticité inférieur à celui du carbure de silicium, dont la concentration décroît sur l'épaisseur de couche de l'intérieur vers l'extérieur.

2. Elément selon la revendication 1, caractérisé en ce que l'autre composant contient du silicium.

3. Elément selon la revendication 2, caractérisé en ce que les autres composants de silicium comprennent du nitrure de silicium et/ou de l'oxyde de silicium.

4. Elément selon l'une des revendications précédentes, caractérisé en ce que la surface (6) du revêtement (2) est formée par la couche à gradient d'indice (4).

5. Elément selon l'une des revendications précédentes, caractérisé en ce que la teneur en carbure de silicium dans la couche à gradient d'indice (4) augmente en continu sur l'épaisseur de couche de l'intérieur vers l'extérieur.

6. Elément selon l'une ou plusieurs des revendications 1 à 5, caractérisé en ce que la couche à gradient d'indice (4) comprend du silicium et du carbure de silicium et en ce que dans la zone de la surface (6) du revêtement (2), la teneur en silicium métallique dans la couche à gradient d'indice (4) est égale à zéro.

7. Elément selon l'une ou plusieurs des revendications, caractérisé en ce que l'épaisseur de la couche à gradient d'indice (4) est comprise entre 5 µm et 100 µm.

8. Elément selon l'une ou plusieurs des revendications, caractérisé en ce qu'en-dessous de la couche à gradient d'indice (4) est placée une couche intercalaire (3) en silicium.

9. Elément selon l'une ou plusieurs des revendications, caractérisé en ce que la surface du composant (1) est rendue rugueuse par un procédé chimique.

10. Elément selon la revendication 9, caractérisé en ce que la surface de l'élément (1) est rendue rugueuse sur une profondeur moyenne de rugosité de 1 µm.
